# EUROPEAN PATENT SPECIFICATION

(11) **EP 1 331 839 B1**
(45) Date of publication and mention of the grant of the patent: **14.05.2008**
(21) Application number: 02001580.6
(22) Date of filing: 23.01.2002
(51) Int. Cl.: H05K 9/00, H01L 23/60, B23B 7/06, B65D 75/26, B23B 27/08

(54) **Electronic component packaging**
Verpackung von elektronischen Bauteilen
Emballage pour composants électroniques

(43) Date of publication of application: 30.07.2003
(73) Proprietor: ADVANCED TECHNOLOGY MATERIALS, INC., Danbury, CT 06810 (US)
(72) Inventor: Vanhamel, Steven, 3540 Herk-de-Stad (BE); Claes, Tom, 3500 Hasselt (BE)
(74) Representative: Bird, William Edward

(56) References cited:
- US-A- 4 407 872
- US-A- 5 314 732
- US-A- 5 739 463
- US-A- 6 094 361

## Description

### FIELD OF THE INVENTION

This invention relates to packaging and in particular to packages that are suitable for storage and transportation of goods that require protection from environmental dangers, such as electrical hazards, humidity and oxygen. Such goods may comprise for example electronic components and circuits or medical products, any of which may carry associated labeling. The present invention also relates to sheet material used in such packages and to methods of manufacture of such material and packages.

### BACKGROUND TO THE INVENTION

The storage, protection and transport of some goods such as electronic components and circuits or some medical products is known to be risky for their well being. It is desirable to protect these goods from the potentially damaging effects of electrostatic build-up, as it may attract contaminants that harm the goods or may result in the discharge of a spark that might damage or destroy certain goods. In addition to providing electrostatic shielding, it is also preferred for an electrical protection ply to provide electrostatic dissipation (ESD) to dissipate electrostatic charge that may build up or otherwise appears despite the electrostatic shielding effects, e.g. due to friction. Beyond protection against the effects of electrostatic discharges, it is also desirable for the same electrical protection ply to try and reduce the potential for damage that might be caused by electromagnetic effects, e.g. radio frequency or other electromagnetic interference (RFI/EMI).

As a further consideration, it is also desirable to try to protect many of these goods against potential environmental hazards, such as for example the effects of humidity and of oxygen. Air ingress is a particular route for oxygen and humidity to gain access to the packaged materials.

It is known to provide flexible protective envelopes that include a metalized layer designed to provide protection against electrical and environmental damage. Some such envelopes include material which is opaque rendering it difficult to inspect goods or labeling inside the packaging, such as for example thick laminates that incorporate a metal layer.

There have been proposals in the prior art to try and alleviate some of the above-mentioned problems associated in dealing with such goods, one example of which may be found in US 5,739,463. In this prior art proposal, a protective flexible envelope is used to protect a printed circuit board. The envelope is generally opaque, but is provided with windows of material having no metallic layer and through which certain aspects of the goods inside the envelope can be inspected. These windows are made of a plastic sheet coated with indium tin oxide (ITO) or another inorganic oxide. The absence of a metal layer helps with transparency but works against electrostatic protection.

In US4407872, a sheet material for packaging electronic parts consists of a laminated material which comprises a transparent plastic film layer and a thin metal film layer having. The sheet material is heat-sealable at the surface of said metal film layer. An envelope for packaging electronic parts is made of the sheet material by heat-sealing in a state of disposing the plastic film layer outside.

### SUMMARY OF THE INVENTION

It is an object of the present invention to provide improved packaging that is suitable for storage and transportation of goods. It is also an object of the present invention to provide an improved package which includes protection against electrostatic discharge and also provides environmental sealing, for example against ingress of vapor, humidity or oxygen, while at the same time allowing visual inspection of at least some aspect of items inside the package. It is a further object of this invention to provide methods and materials for producing improved packaging.
Accordingly, the present invention provides a package adapted to receive and protect goods, such as for example electronic components, said package having a body which includes a translucent window formed from a flexible laminated sheet material, a first layer of said laminated sheet material comprising an environmental protection ply including an inorganic oxide deposited onto a first carrier ply, a second layer of said flexible sheet material comprising an electrical protection ply including an electrically conductive material deposited onto a second carrier ply, said first and second carrier plies being laminated together in a back-to-back relationship and at least one and preferably both said layers having a heat-sealable outer ply laminated thereto. In this manner, a package according to the present invention provides at least a portion thereof comprising a translucent flexible sheet which is adapted for use as a window through which items such as goods or associated labeling can be inspected whilst in the package, e.g. in order to monitor the state of the items and/or to monitor conditions present or past to which items therein have been subjected.

Said carrier plies may be laminated together using therebetween at least one of an adhesive and a heat-sealable ply.

The present invention also provides a package adapted to receive and protect goods, such as for example electronic components, said package having a body which includes a translucent window formed from a flexible laminated sheet material, a layer of said laminated sheet material comprising an environmental protection ply including an inorganic oxide deposited onto a carrier ply and an electrical protection ply including an electrically conductive material deposited onto an opposite side of said carrier ply, at least one and preferably both said protection plies having a heat-sealable outer ply laminated thereto.

Said electrically conductive material may include a metal, such as aluminum applied for example by at least one of a sputter or vapor deposition technique.

Said window may completely cover an opening defined in said body and may be fixed in place by one or more heat seals.

The size of said opening may be within a predetermined maximum, said maximum size being limited by the maximum allowable rate at which contamination may pass into said body through said window.

Said window may be positioned substantially on one side of said body.

Said window may extend substantially all the way over at least one side of said package, for example from side-to-side or top-to-bottom. Said window may therefore be co-extensive with at least one dimension of said package and may, for example, be in the general form of a translucent stripe or bar.

Said body may include one or more sheets of flexible metal film laminate, said metal film laminate preferably having at least one side comprising a heat-sealable outer ply.

Said environmental protection layer may include an organically modified ceramic (ORMOCER) or an organically modified silicate (ORMOSIL).

The present invention also provides a method of manufacturing a package adapted to receive and protect goods, such as for example electronic components, the method including:
a) providing a body for said package, said body defining an opening, and preferably comprising a metal film laminate;
b) providing first and second translucent layers of flexible laminated sheet material, said first layer having an environmental protection ply including an inorganic oxide and said second layer having an electrical protection ply including a conductive material;
c) laminating said first and second layers together to form a window sheet; and
d) sealing said window sheet onto said body across said opening, so as to integrate said window sheet into said body as a window thereof, whereby said window is useable for viewing items inside said package, for example goods or labeling.

The method may include forming said package from a front panel and a back panel, said back panel preferably comprising a metal film laminate and said front panel comprising at least one strip of metal laminate combined with at least one strip of said window sheet. The method may include overlaying said front and back panels and forming said package by heat sealing said front panel to said back panel by means of one or more heat seals running substantially around a periphery of said overlying panels, leaving an entrance portion at least temporarily unsealed for insertion of goods into said package. The method may include forming said package from overlying moving webs of front and rear panel material, in which case the method may include forming a succession of said packages by heat sealing said overlaying webs to each other by means of transverse and longitudinal heat seals. A said series may comprise one or more packages formed by means of two longitudinal heat seals and at least one transverse heat seal. A said series of packages may in the alternative or in addition comprise one or more packages formed by means of two transverse heat seals and at least one longitudinal heat seal. A said longitudinal or transverse heat seal being formed respectively substantially along or transverse to the direction of travel of a said moving web. The method may include heat sealing said moving webs to each other and cropping off packages so formed.

The present invention also provides a flexible laminated sheet material suitable for use as a translucent window in a package, wherein said sheet material comprises an environmental protection ply including an inorganic oxide deposited onto a first carrier ply and having a heat-sealable ply laminated onto said deposited inorganic oxide, an electrical protection ply including an electrically conductive material deposited onto a second carrier ply and having a heat-sealable ply laminated onto said deposited conductive material, said first and second carrier plies being laminated together in a back-to-back relationship. The lamination of the carrier plies may be performed using at least one of an adhesive or a heat-sealable ply, e.g. a heat-sealable ply made from polyethylene or a similar material.

The present invention also provides a flexible laminated sheet material suitable for use as a translucent window in a package, wherein said sheet material comprises an environmental protection ply including an inorganic oxide deposited onto a carrier ply and an electrical protection ply including an electrically conductive material deposited onto said carrier ply, at least one side and preferably both sides of said sheet material comprising a heat-sealable outer ply laminated thereto. Said inorganic oxide and said electrically conductive material may be deposited onto opposite sides of said carrier ply.

Said environmental protection ply may comprise an oxide of silicon, preferably silicon dioxide (SiO₂) deposited by, for example, a vapor deposition technique. Said electrically conductive material may comprise a metal, said metal comprising for example aluminum and being applied for example by a sputter or vapor deposition technique. The or each said carrier ply may comprise a polyethylene terephalate (PET). The environmental protection ply of said flexible sheet material may include an organically modified ceramic (ORMOCER) or an organically modified silicate (ORMOSIL).

### BRIEF DESCRIPTION OF THE DRAWINGS

The invention will now be described by way of example only and with reference to the accompanying drawings, in which:
Figure 1 is a schematic plan view of packaging according to a first embodiment of the present invention;
Figure 2a is a side view in cross section along the line A-A in Figure 1;
Figure 2b is a side view in cross section of a variation of the embodiment of Figure 2a;
Figure 3a is a simplified view of Figure 2b;
Figure 3b is a side view in cross-section of a second embodiment of the present invention;
Figure 3c is a side view in cross-section of a variation to the second embodiment;
Figures 4a and 4b are plan views of materials suitable for use in manufacturing a portion of the packaging of the embodiments of Figures 1 to 3c;
Figure 4c is a plan view of manufacturing steps usable in forming embodiments of the invention, using by way of example the material of Figure 4b;
Figure 5 is a plan view of a third embodiment of the present invention;
Figures 6a and 6b are sections through materials suitable for use in manufacturing a portion of the packaging of the embodiments of Figures 1 to 5;
Figure 7 is a section through a substantially translucent window made using the materials of Figures 6a and 6b;
Figure 8 is a section through an alternative embodiment of the window of Figures 6a to 7; and
Figure 9 is a section through a variation to the material used in Figure 6a and comprises an arrangement that may be substituted for the equivalent arrangement of Figure 6a used in the embodiments of Figures 7 and 8.

### DETAILED DESCRIPTION OF PREFERRED EMBODIMENTS

The present invention will now be described with reference to certain embodiments and with reference to the above mentioned drawings. Such description is by way of example only and the invention is not limited thereto but only by the appended claims.

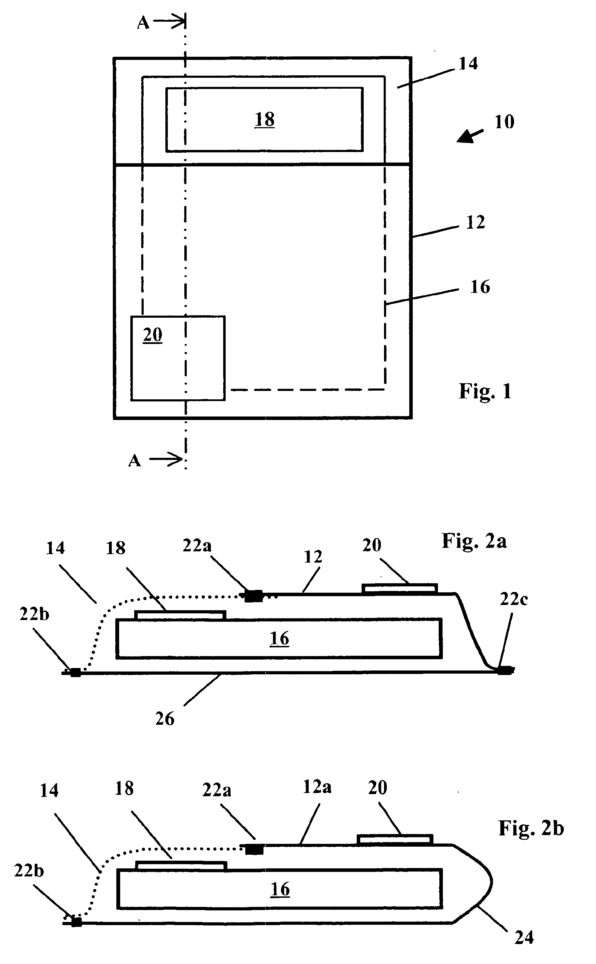

Referring to the Figures, and for the moment in particular to Figures 1 and 2a, a package 10 is in the form of a bag/envelope and comprises a body made of flexible sheet material in the form of a front panel 12 and a back panel 26. The material used to provide the front and back panels 12, 26 is a flexible metal laminate, comprising for example a 20 micron thick aluminum foil/film laminated in between a carrier ply on one side and a heat-sealable ply on the other side. The carrier ply may comprise a polyester material, preferably polyethylene terephthalate (PET), but may be made from other materials such as orientated polypropylene (OPP) and orientated polyamide (OPA). The heat-sealable ply may comprise for example polyethylene (PE).

The body 12, 26 defines an opening which extends all the way across its front side 12 and around which is hermetically sealed a window 14. The window 14 comprises a translucent laminated plastic sheet having outer plies of a heat-sealable material, such as for example polyethylene (PE), and will be described in greater detail below. The provision of a heat-sealable outer ply on each side of the window 14 allows it to be heat sealed to the heat-sealable side of the panels 12, 26. In the embodiment disclosed with reference to Figure 2a, the heat-sealable side of the each panel 12, 26 faces inboard of the package 10, which presents their respective heat-sealable sides towards each other and allows them to be selectively joined to each other, e.g. by one or more lines of heat-sealing 22c. It will be noted, however, that this configuration presents the PET side of the panels 12, 26 outboard of the package and it is difficult to apply a heat seal to this side. This means that it is preferable to create the hermetic seal around the opening by a heat-seal 22a between the outboard facing side of the window 14 and the inboard side of the front panel 12 and by applying one or more further heat-seals 22b between the inboard facing side of the window 14 and the inboard side of the back panel 26. The package 10 is also heat sealed along its sides to define a storage space for receiving and protecting goods 16, such as for example electronic components and circuits or medical goods.

The metal laminate forming the front and back panels 12, 26 provides protection against the penetration of environmental contaminants such as humidity or oxygen. The conductive nature of the aluminum layer provides electrical protection in the form of both electrostatic shielding protection (ESP) and electrostatic dissipation (ESD). It also provides protection against the effects of electro-magnetic interference (EMI), such as for example radio frequency interference (RFI). These environmental and electrical protective properties are also provided by the window 14 as will be described below, although the requirement to make the window 14 translucent may reduce the level of protection provided by the window 14 in comparison to the panels 12, 26 of metal film laminate.

The window 14 is used to provide a substantially clear view into the inside of at least a portion of the package 10, so as to enable inspection of items held in there, e.g. goods 16 or labeling 18. The labeling 18 may comprise any format suitable for identifying the goods, e.g. a simple printed or handwritten label, a barcode, or hologram or may simply comprise a part number or similar indicia forming part of the goods themselves. In addition or in the alternative, the labeling may be in a form suitable for monitoring the condition of the goods or environmental conditions past or present inside the packaging, e.g. a humidity indicator.

The goods 16 which are to be protected are introduced into the package 10 before all the seals are made, the operation preferably being performed in a clean environment and/or using sterilization as appropriate. The order in which the heat seals 22a, 22b, 22c are made may be predetermined, as will be discussed below, but may also be variable and should take account of the nature and shape of the goods 16 that are being sealed in the package 10. For convenience, the goods in this first instance will be presumed to be electronics hardware 16 bearing a label 18 carrying information which allows inspection of the hardware 16 without disturbing the hermetic integrity or electrical protection afforded by the package 10.

The package 10 optionally carries a further label 20 attached to its outside. This label 20 may carry, for example, information which is not necessarily directly related to identification of the nature of the goods 16 themselves but rather perhaps to their delivery, storage or use details, e.g. batch numbering, supply source, date of packing, use-by-date, dispatch details, customs information and customer.

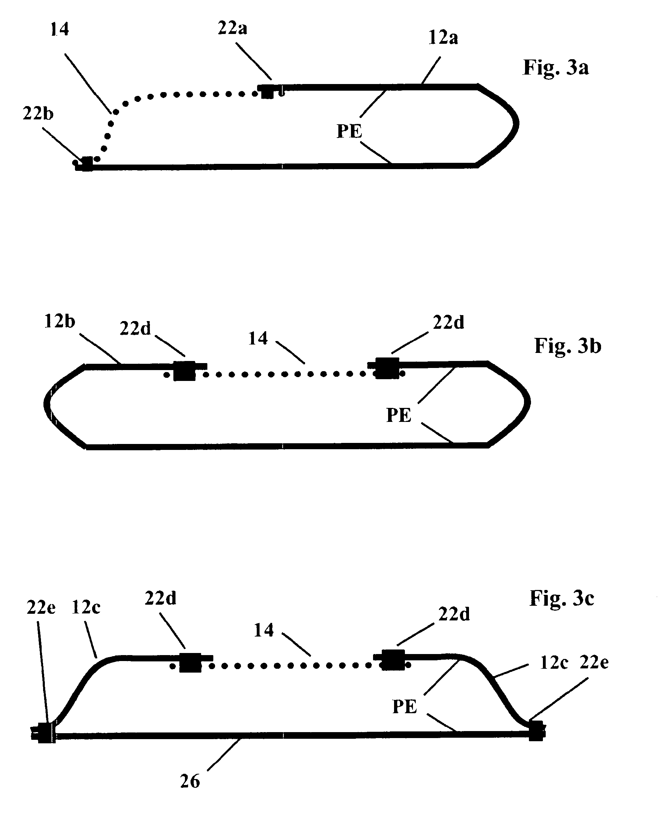

A first variation to the structure of the embodiment above is disclosed with particular reference now also to Figures 2b and 3a. Instead of using separate front and back panels 12, 26, a single panel 12a of the metal laminate is used to form the body/bag, the panel 12a being folded over with its heat-sealable layer (PE) inboard and in such a manner that the panel 12a comes back on itself about the fold 24. The remainder of the structure of this variation is the same as that of the structure described in relation to Figure 2a and the same description and reference numerals apply.

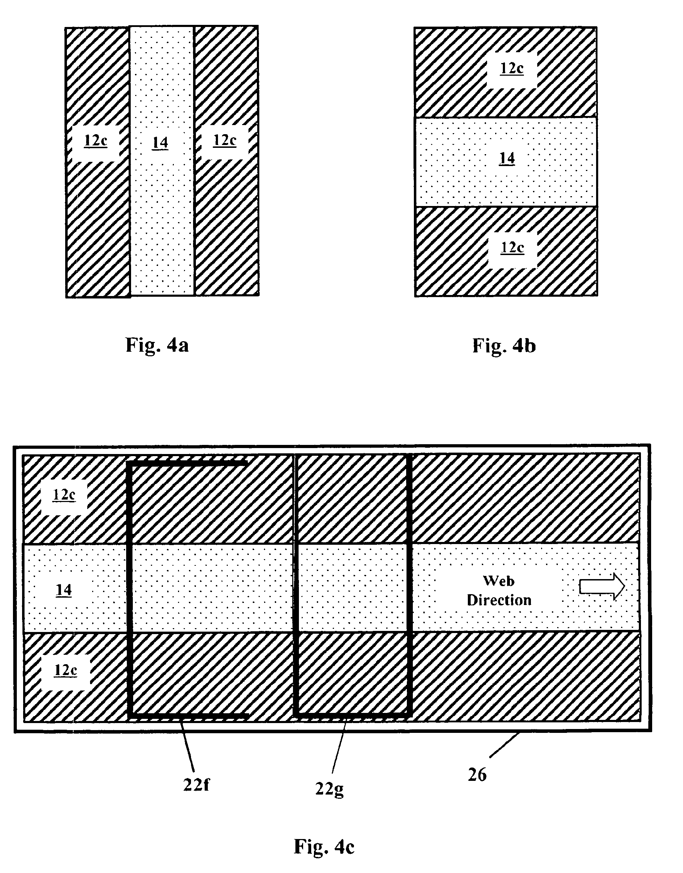

A second embodiment of the invention is disclosed with reference now also to Figure 3b. This embodiment is a variation of the arrangement described above in relation to Figures 2b and 3a, in that a metal laminate sheet 12b is folded or wrapped around itself on two ends or two sides, again such that the heat-sealable side (PE) is inboard of the package/bag. The window 14 is then hermetically sealed across an opening between the two edges of the sheet 12b by lines of heat-sealing 22d. The open and opposing ends of the package/bag thus formed can then be heat-sealed as appropriate for the goods being packaged. Examples of sealing techniques are discussed below with particular reference to Figure 4c.

The structure of the second embodiment may be varied such that it is made from a series of one-time separate panels 12c, 14, 12c, 26. Initially, separate strips 12c of the metal film laminate are heat sealed 22d PE side down onto a strip 14 of the window sheet. This panel 12c, 14, 12c, referred to for convenience as a front panel, is then placed with the PE sides of the metal laminate strips 12c face down onto the PE side of a back panel 26 of the metal laminate and joined by heat sealing 22e. It will be appreciated that the versions of packaging shown with respect to Figure 3b and 3c particularly lend themselves to orientation of the window 14 as a strip running all the way over the package 10, e.g. from top-to-bottom or from side-to-side, as shown and discussed now with particular reference to Figures 4a and 4b respectively.

A triple strip 12c-14-12c which may be used in creating the base material for a front panel of the version discussed with reference to Figure 3c, can be formed from three initially separate rolls running under fixed heating bars, the outer strips 12c overlying the inner strip 14 along edges of their PE sides. The resulting triple strip 12c-14-12c may be formed continuously within the limitations of supply roll length and cropped off as formed or rolled up for later use and cropped off when required. Panels 12c-14-12c which are created by cropping the strip material may then be wrapped around themselves or goods 16 such that the outer edges of the metal laminate strips 12c abut PE side to PE side and are then sealed to provide essentially the same structure as the second embodiment (Figure 3b) having a lengthways/vertically orientated window 14 extending in a top-to-bottom orientation substantially all the way over the package. In similar fashion, a panel 12c-14-12c may be wrapped around such that the other pair of edges abut, i.e. each strip 12c-14-12c abuts the opposing ends of its constituent strips PE side to PE side and forms a package/bag having a sideways/transverse orientated window 14 extending in a side-to-side orientation substantially all the way over the package.

Further variations can be made if necessary, such as for example cropping the strip along diagonals so as to form diagonal windows. In addition, panels 12c-14-12c formed from the triple strip 12c-14-12c may be used in the first embodiment (Figure 1, Figure 2a) in place of the panel and window combination 12, 14 of that embodiment, thereby extending the possible range of orientation of the window 14. In addition, panels/rolls may be formed from a greater or lesser number of constituent strips, e.g. a simple double strip 12, 14 suitable for the embodiment of Figure 1 or multiple window strips 12c-14-12c-14-12c; 14-12c-14-12c-14 which may comprise outer strips of either metal laminate 12c or of window material 14 bounding corresponding inner strips of the window sheet 14 or the metal laminate 12 as required (none illustrated).

Two examples of methods by which a panel 12c-14-12c may be heat sealed onto a back panel 26 are disclosed with reference to Figure 4c. The example is disclosed with particular reference to a moving top web of triple strip 12c-14-12c material running over a moving lower web of back panel 26. It will be appreciated however that, as each version of the strip 12c-14-12c faces the back panel 26 PE side to PE side regardless of how many strips 12c, 14 are used to create the moving top web, the same sealing techniques disclosed may be used for each version of top web. It will also be noted that the rear panel 26 may also comprise a composite of strips 12c, 14 of metal laminate and window sheet as required without exceeding the maximum permissible ingress/egress of contamination.

A first version of heat seal 22f comprises a longitudinal heat seal along a portion of an outboard strip 12c-14-12c with a transverse heat seal across all constituent strips 12c-14-12c and a further longitudinal heat seal along a portion of an opposing outboard strip 12c. This version creates a package 10 having an entrance across the constituent strips 12c-14-12c, through which goods may enter the package 10.

A second version of heat seal 22g between the top web/panel 12c-14-12c and a backing web/panel 26 comprises a first transverse heat seal across all constituent strips 12c-14-12c, a longitudinal heat seal along a portion of an outboard strip 12c and a further transverse heat seal across all constituent strips 12c-14-12c. This version creates a package 10 having an entrance along one constituent strip 12c.

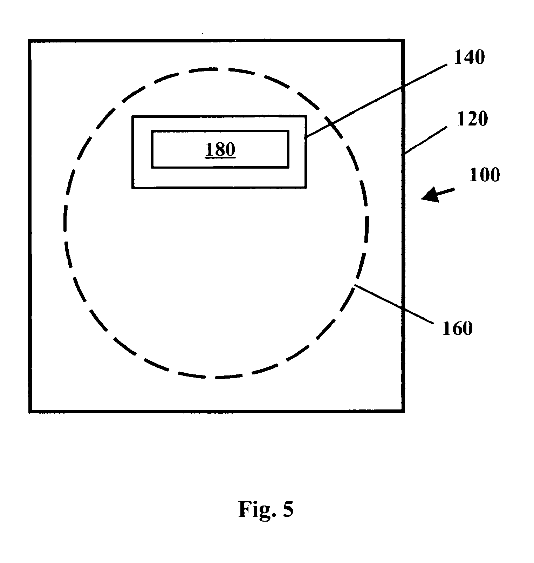

A third embodiment is disclosed with particular reference to Figure 5, in which the packaging is in the form of an envelope 100 formed from flexible metal laminate sheet material 120 having a hole cut out of it in one face. The flexible metal laminate may be the same material discussed above in relation to the first and second embodiments. The opening thus created is covered by a window 140 which is hermetically heat-sealed to the sheet material 120 all the way around. The opening, and consequently the window 140, is positioned wherever necessary on the sheet 120 and is of sufficient size to enable inspection of an aspect of items inside the envelope 100. By way of example, in this case the items are shown schematically as an electronics disc 160 bearing a label 180 used for identification. No label is shown on the outside of the envelope 100, although provision of such indicia is optional as in the first embodiment 10. The envelope may be made from separate panels in similar fashion to the front and back panels 12, 26 of the first embodiment, or may be made for example by folding over a single sheet/panel in similar fashion to the second embodiment.

It should be noted that the size of the window 14; 140 in any embodiment should be controlled to within a predetermined maximum size, as the window 14; 140 may not provide the same level of environmental and electrical protection as the metal laminate. For example, water vapor transmission of some translucent windows 14 has been found to be in the region of 0.1g/m² and oxygen transmission has been found to be in the region of 0.1 cm³/m² per day per bar of O₂. The maximum size should be limited by the maximum allowable rate at which contamination may pass into the body 10; 100 through the window 14; 140. This will often be limited by level or rate at which items inside the package can absorb contamination penetrating through the window 14; 140. A suitable range for water vapor transmission may comprise less than 0.5, preferably less than 0.2 and most preferably less than about 0.1g/m². In similar fashion, a suitable range for oxygen transmission may comprise less than 0.5, preferably less than 0.2 and most preferably less than about 0.1 cm³/m² per day per bar of O₂.

In the first and second embodiments only a single window 14 was provided. It will be apparent, in particular from the third embodiment 100, that a plurality of such windows 14; 140 can be provided in any embodiment 10; 100 and that they 14; 140 can be placed in other positions in dependence on the nature of the particular inspection called for, within the limitations imposed by the rate at which contamination can be allowed to pass through the window 14 and the total level of contamination/EMI allowable for the goods 16; 160 in question.

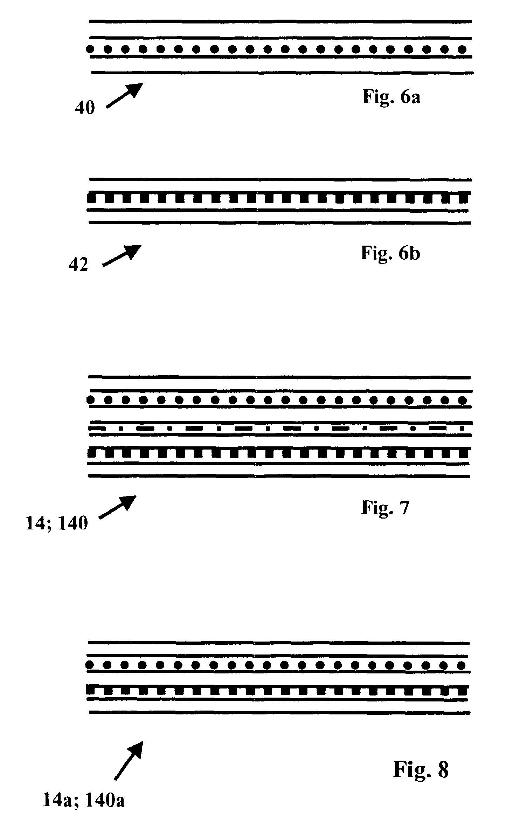

Referring also to Figures 6a, 6b and 7 to 9, particular consideration will now be given to the structure of the window 14; 140. Each window 14; 140 comprises a plurality of overlapping layers of translucent and flexible laminated sheet material, those layers being laminated together in a back-to-back relationship. The translucence of the window 14; 140 can be considered in terms of its light transmissibility, which may preferably be kept within the order of at least 40% +/- 10%. It will be appreciated that the light transmissibility through a window sheet 14; 140 according to the present invention will vary in dependence on the properties of the layer materials used to form it and possibly further in dependence on the manner in which they are joined in their back-to-back relationship, of which some non-limiting joining techniques will be discussed further below. To consider a product suitable for use as such a window sheet 14; 140, the important feature is that it should be sufficiently translucent so as to permit the inspection of the required features of the package contents, be that for example by eye or by a scanning device such as a barcode reader. To that end, light transmissibility testing should preferably be carried out and a transmissibility of at least 30% sought, preferably 35% and most preferably of 40% or more.

A first sheet 40 is disclosed with particular reference to Figure 6a and comprises an environmental protection ply 30 in the form of a layer of an inorganic compound such as silicon dioxide SiO₂. This material SiO₂ is favored for optimization of cost versus volume and performance, although other materials such as aluminum oxide (Al₂O₃) may be considered for this purpose. The environmental protection material/ply is deposited onto a carrier ply, for example by vapor deposition/electron beam evaporation, and a typical deposition thickness is in the region of 1.8g/m². The deposition thickness of a ply may effect the light transmissibility through it and variations in the thickness of the layer may be used to provide different translucence, for example a thicker ply such as one comprising up to about 2.2g/m² may prove useful if greater protection is required and the translucence can be compromised accordingly. On the other hand, if greater translucence is required and it is the environmental protection that can be compromised, the deposition thickness may instead be reduced and a layer comprising down to about 1.5g/m² may prove usable.

The carrier ply comprises a polyester material, preferably polyethylene terephthalate (PET), but may be made from other materials provided that they are suitable for deposition of the environmental protection ply. Alternatives such as orientated polypropylene (OPP) and orientated polyamide (OPA) may be found suitable.

The exposed side of the inorganic compound is then covered by lamination thereto of an outer ply 28 in the form of a translucent plastic sheet. The outer ply 28 is made for example from a heat sealable material, such as for example a low-density polyethylene (PE). Other preferably heat-sealable materials may be considered, such as for example polypropylene.

A second laminated sheet 42 is disclosed with particular reference to Figure 6b and comprises an electrically conductive ply formed using a conductive material such as a metal, preferably aluminum. The metal is deposited, for example using a sputter or vapor deposition technique, onto a carrier ply of translucent plastics sheet. The deposition thickness may comprise, for example, anywhere between 100 and 1500 Angstroms thick. The carrier ply may be made for example from polyethylene terephthalate (PET) or an equivalent. In similar fashion to the environmental protection layer, the exposed side of the electrically conductive ply 32 is then covered by lamination thereto of an outer ply in the form of a translucent plastics sheet 28, made for example from a heat sealable material such as a low density polyethylene (PE) or equivalent.

The two laminated sheets 40, 42 are then laminated together by joining them in a back-to-back relationship across their respective carrier plies, using in this embodiment an adhesive bonding agent 36 and thereby forming a window sheet. Alternative means of joining the two sheets 40, 42 may be used, such as for example joining the sheets 40, 42 by means of a heat-sealable layer, e.g. a polyethylene layer extruded between them. This forms a one-piece window sheet 14; 140 in which the lamination of the constituent layers is a necessary step in order to form a closed bag, as otherwise openings may be left in the bags. The unitary window sheet 14; 140 also provides ease of handling during manufacture of packages, e.g. in comparison to trying to use separate sheets 40, 42 to form the window 14; 140 by simply overlaying them one-on-top of each other. Furthermore, lamination of the sheets 40, 42 together reduces the chances of vapor or other contaminants getting in between them and potentially reducing the translucence of the combination 40, 42, e.g. by mist forming on or in between the sheets 40, 42 which might happen if they were to be left unlaminated.

In positioning the window sheet 14; 140, the outboard facing side may be the side 40 incorporating the environmental protection ply/layer 30, such that the electrical protection ply/layer 32 is protected from externally originating physical contamination, such as humidity, vapor or oxygen/air entry or other chemical contamination. This arrangement may, however, be reversed.

The window sheet 14; 140 of the present invention alleviates the situation found in some prior art arrangements in which one or the other of environmental or electrical protection is compromised in order to allow inspection of packaged goods or the effects of the environment inside the packaging. The environmental protection layer and the electrical protection layer combine to provide both types of protection afforded by the surrounding metal laminate 12, 12a, 12b, 12c, 26, the conductive nature of the electrical protection layer 42 providing electrostatic shielding protection (ESP), electrostatic dissipation (ESD) and protection against the effects of electro-magnetic interference (EMI/RFI).

In Figure 8 an embodiment is disclosed in which both the environmental protection ply and the electrical protection ply are deposited onto opposite sides of the same PET carrier ply. This forms a combination ply 34 that is then sandwiched between two layers of outer ply, each of which is preferably in the form of a heat sealable material such as a polyethylene (PE) sheet. This eliminates the need to provide separate layers for environmental and electrical protection and then to laminate them together, but might necessitate custom machinery or a special production run to make it. This may contrast financially unfavorably with starting from separate sheets 40, 42, as suitable such material is available and laminating the two types together is a cost effective way of realizing practical embodiments of the present invention without major investment in tooling.

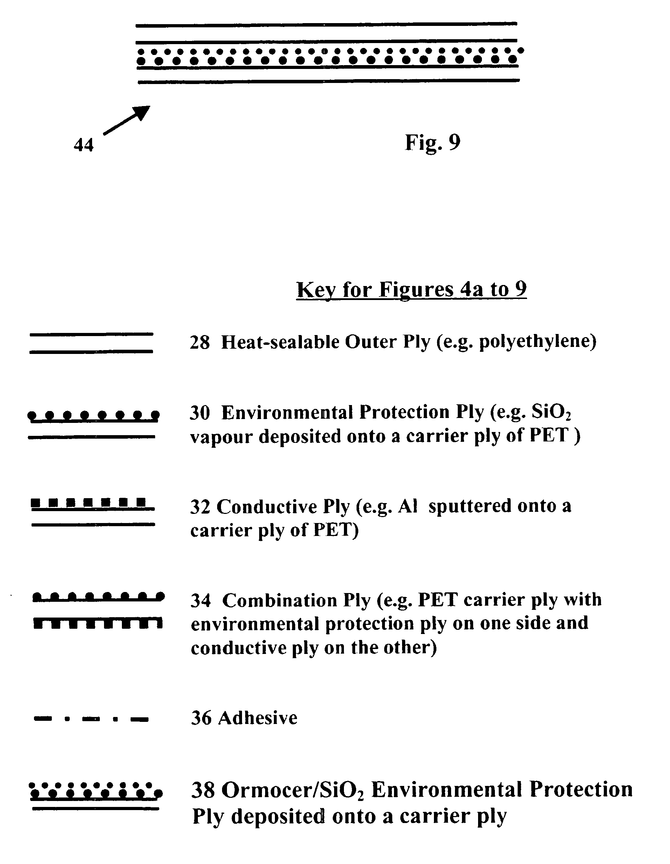

A further embodiment is disclosed with particular reference to Figure 9, which may be considered a variation of the environmental protection layer discussed in relation to Figure 6a. In this variation, once the inorganic oxide (e.g. SiO₂) has been deposited onto the PET carrier ply, a further level of environmental protection is added/deposited onto the carrier ply before the outer ply 28 is included. A suitable material for such extra protection is one that falls into the group known generically as organically modified ceramics and referred to sometimes in the art as ORMOCERs of which a sub-group is referred to as organically modified silicates (ORCOSILs). These materials can be produced by the sol-gel process and are preferably applied in a similar fashion to varnish layers. This modification to the environmental protection layer is applicable to each embodiment of the present invention and reduces the transmission of environmental hazards through the or each window 14.

## Claims

1. A flexible laminated sheet material suitable for use as a translucent window in a package wherein said sheet material comprises an environmental protection ply (30, 38) including an inorganic oxide deposited onto a first carrier ply and having a heat-sealable ply (28) laminated onto said deposited inorganic oxide, **characterized in that** an electrical protection ply (32) including an electrically conductive material is deposited onto a second carrier ply and having a heat-sealable ply (28) laminated onto said deposited conductive material, said first and second carrier plies being laminated together in a back-to-back relationship.

2. A flexible laminated sheet material according to claim 1, wherein said carrier plies are laminated together using therebetween at least one of an adhesive (36) and a heat-sealable ply.

3. A flexible sheet material according to any one of claims 1 to 2, wherein said inorganic oxide comprises an oxide of silicon, preferably silicon dioxide (SiO₂), and is deposited by for example a vapor deposition technique.

4. A flexible sheet material according to any one of claims 1 to 3, wherein said electrically conductive material comprises a metal, said metal comprising for example aluminum and being applied for example by a sputter or vapor deposition technique.

5. A flexible sheet material according to any one of claims 1 to 4, wherein the or each said carrier ply comprises a polyethylene terephalate (PET).

6. A flexible sheet material according to any one of claims 1 to 5, wherein said environmental protection ply (38) includes an organically modified ceramic (ORMOCER) or an organically modified silicate (ORMOSIL).

7. A package (10, 100) adapted to receive and protect goods, such as for example electronic components, said package having a body (12, 26) which includes a translucent window (14, 140) formed from a flexible laminated sheet material according to any one of the claims 1 to 6.

8. A package (100) according to any preceding claim, wherein said window (140) completely covers an opening defined in said body and is fixed in place by one or more heat seals.

9. A package according to claim 8, wherein the size of said opening is within a predetermined maximum, said maximum size being limited by the maximum allowable rate at which contamination may pass into said body through said window.

10. A package according to 8 to 9, wherein said window is positioned substantially on one side of said body.

11. A package according to claim 8 to 10, wherein said window extends substantially all the way over at least one side of said package, for example from side-to-side or top-to-bottom.

12. A package according to claim 8 to 11, said body being including one or more sheets of flexible metal film laminate, said metal film laminate preferably having at least one side comprising a heat-sealable outer ply.

13. A method of manufacturing a package adapted to receive and protect goods, such as for example electronic components, the method including:
a) providing a body for said package, said body defining an opening and preferably comprising a metal film laminate;
b) providing first and second translucent layers of flexible laminated sheet material, said first layer having an environmental protection ply including an inorganic oxide and said second layer having an electrical protection ply including a conductive material;
c) laminating said first and second layers together to form a window sheet; and
d) sealing said window sheet onto said body across said opening, so as to integrate said window sheet into said body as a window thereof, whereby said window is useable for viewing items inside said package, for example goods or labeling.

## Patentansprüche

1. Flexibles, laminiertes Bahnmaterial, welches zur Verwendung als ein durchsichtiges Fenster bei einer Verpackung geeignet ist, wobei das Bahnmaterial eine Lage zum Schutz vor Umwelteinflüssen (30, 38) aufweist, welche ein anorganisches Oxid umfasst, das auf einer ersten Trägerlage abgeschieden ist, und eine Heißklebelage (28) aufweist, welche auf das abgeschiedene, anorganische Oxid laminiert ist,
**dadurch gekennzeichnet,**
**dass** eine elektrische Schutzlage (32), welche ein elektrisch leitfähiges Material umfasst, das auf eine zweite Trägerlage abgeschieden ist, und eine Heißklebelage (28) aufweist, die auf das abgeschiedene, leitfähige Material laminiert ist, wobei die erste und zweite Trägerlage in aufeinanderfolgender Beziehung zusammenlaminiert sind.

2. Flexibles, laminiertes Bahnmaterial nach Anspruch 1, wobei die Trägerlagen unter Verwendung wenigstens eines zwischenliegenden Haftmittels (36) oder einer zwischenliegenden Heißklebelage zusammenlaminiert sind.

3. Flexibles Bahnmaterial nach Anspruch 1 oder 2, wobei das anorganische Oxid ein Siliziumoxid, vorzugsweise Siliziumdioxid (SiO₂), aufweist und beispielsweise mittels eines Aufdampfverfahrens abgeschieden wird.

4. Flexibles Bahnmaterial nach einem der Ansprüche 1 bis 3, wobei das elektrisch leitfähige Material ein Metall aufweist, wobei das Metall beispielsweise Aluminium aufweist und beispielsweise mittels eines Sputter- oder Aufdampfverfahrens abgeschieden wird.

5. Flexibles Bahnmaterial nach einem der Ansprüche 1 bis 4, wobei die oder jede der Trägerlagen ein Polyethylenterephthalat (PET) aufweist.

6. Flexibles Bahnmaterial nach einem der Ansprüche 1 bis 5, wobei die Lage zum Schutz vor Umwelteinflüssen (38) eine organisch modifizierte Keramik (ORMOCER) oder ein organisch modifiziertes Silikat (ORMOSIL) aufweist.

7. Verpackung (10, 100), welche für eine Aufnahme und einen Schutz von Artikeln, wie beispielsweise elektronische Komponenten, ausgebildet ist, wobei die Verpackung einen Körper (12, 26) aufweist, welcher ein durchsichtiges Fenster (14, 140) umfasst, das aus einem flexiblen, laminierten Bahnmaterial nach einem der Ansprüche 1 bis 6 gebildet ist.

8. Verpackung (100) nach einem der vorhergehenden Ansprüche, wobei das Fenster (140) eine Öffnung, welche in dem Körper ausgebildet ist, vollständig abdeckt und mittels einer oder mehrerer Heißsiegel gehalten ist.

9. Verpackung nach Anspruch 8, wobei die Größe der Öffnung innerhalb eines vorbestimmten Maximums liegt, wobei die maximale Größe von der maximal zulässigen Rate begrenzt wird, mit welcher Kontamination in den Körper durch das Fenster dringen darf.

10. Verpackung nach Anspruch 8 oder 9, wobei das Fenster im Wesentlichen an einer Seite des Körpers angeordnet ist.

11. Verpackung nach einem der Ansprüche 8 bis 10, wobei sich das Fenster im Wesentlichen vollständig über wenigstens eine Seite der Verpackung, beispielsweise von Seite zu Seite oder von oben nach unten, erstreckt.

12. Verpackung nach einem der Ansprüche 8 bis 11, wobei der Körper ein oder mehrere Schichten aus flexiblen Metallfilmlaminat aufweist, wobei das Metallfilmlaminat vorzugsweise wenigstens eine Seite aufweist, welche eine äußere Heißklebelage umfasst.

13. Verfahren zum Herstellen einer Verpackung, welche für eine Aufnahme und für einen Schutz von Artikeln, beispielsweise elektronische Komponenten, ausgebildet ist, wobei das Verfahren aufweist:
a) Bereitstellen eines Körpers für die Verpackung, wobei der Körper eine Öffnung ausbildet und vorzugsweise ein Metallfilmlaminat umfasst;
b) Bereitstellen einer ersten und zweiten durchsichtigen Schicht aus flexiblen laminierten Bahnmaterial, wobei die erste Schicht eine Lage zum Schutz vor Umwelteinflüssen aufweist, welche ein anorganisches Oxid umfasst, und die zweite Schicht eine elektrische Schutzlage aufweist, welche ein leitfähiges Material umfasst;
c) Zusammenlaminieren der ersten und zweiten Schicht zum Bilden einer Fensterschicht; und
d) Schweißen der Fensterschicht auf den Körper über die Öffnung, sodass die Fensterschicht in den Körper als ein Fenster desselben integriert ist, wobei das Fenster für ein Sehen von Gegenständen innerhalb der Verpackung, beispielsweise von Artikeln oder Etiketten, geeignet ist.

## Revendications

1. Matériau en feuille stratifié souple approprié pour une utilisation en tant que fenêtre translucide dans un emballage, ledit matériau en feuille comprenant une couche de protection vis-à-vis de l'environnement (30, 38) qui comprend un oxyde inorganique déposé sur une première couche de support et qui présente une couche pouvant être thermoscellée (28) stratifiée sur ledit oxyde inorganique déposé, **caractérisé en ce qu'**une couche de protection électrique (32) comprenant un matériau électriquement conducteur est déposée sur une seconde couche de support et comporte une couche pouvant être thermoscellée (28) stratifiée sur ledit matériau conducteur déposé, lesdites première et seconde couches de support étant stratifiées ensemble en étant dos à dos.

2. Matériau en feuille stratifié souple selon la revendication 1, dans lequel lesdites couches de support sont stratifiées ensemble en utilisant entre elles au moins l'un parmi un agent adhésif (36) et une couche pouvant être thermoscellée.

3. Matériau en feuille souple selon l'une quelconque des revendications 1 à 2, dans lequel ledit oxyde inorganique comprend un oxyde de silicium, de préférence du dioxyde de silicium (µSiO₂), et est déposé par exemple par une technique de métallisation sous vide.

4. Matériau en feuille souple selon l'une quelconque des revendications 1 à 3, dans lequel ledit matériau électriquement conducteur comprend un métal, ledit métal comprenant, par exemple, l'aluminium et étant appliqué, par exemple, par une technique de vaporisation ou métallisation sous vide.

5. Matériau en feuille souple selon l'une quelconque des revendications 1 à 4, dans lequel ladite couche ou chacune desdites couches de support comprend du téréphtalate de polyéthylène (PET).

6. Matériau en feuille souple selon l'une quelconque des revendications 1 à 5, dans lequel ladite couche de protection vis-à-vis de l'environnement (38) comprend une céramique modifiée organiquement (ORMOCER) ou un silicate modifié organiquement (ORMOSIL).

7. Emballage (10, 100) adapté pour recevoir et protéger des marchandises, telles que par exemple des composants électroniques, ledit emballage ayant un corps (12, 26) qui comprend une fenêtre translucide (14, 140) formée d'un matériau en feuille stratifié souple selon l'une quelconque des revendications 1 à 6.

8. Emballage (100) selon l'une quelconque des revendications précédentes, dans lequel ladite fenêtre (140) couvre complètement une ouverture définie dans ledit corps et est fixée en place par un ou plusieurs thermoscellages.

9. Emballage selon la revendication 8, dans lequel la taille de ladite ouverture se situe dans une plage de valeur maximale prédéterminée, ladite taille maximale étant limitée par le taux maximal autorisable avec lequel une contamination p eut passer dans ledit corps à travers ladite fenêtre.

10. Emballage selon les revendications 8 à 9, dans lequel ladite fenêtre est positionnée pratiquement d'un côté dudit corps.

11. Emballage selon les revendications 8 à 10, dans lequel ladite fenêtre s'étend pratiquement entièrement sur au moins un côté dudit emballage, par exemple d'un côté à l'autre ou de haut en bas.

12. Emballage selon les revendications 8 à 11, ledit corps comprenant une ou plusieurs feuilles de stratifié à film métallique souple, ledit stratifié à film métallique ayant de préférence au moins un côté comprenant une couche externe pouvant être thermoscellée.

13. Procédé de fabrication d'un emballage adapté pour recevoir et protéger des marchandises, telles que par exemple des composants électroniques, le procédé comprenant :
a) la fourniture d'un corps pour ledit emballage, ledit corps définissant une ouverture et comprenant de préférence un stratifié à film métallique ;
b) la fourniture de première et seconde couches translucides d'un matériau en feuille stratifié souple, ladite première couche ayant une couche de protection vis-à-vis de l'environnement qui comprend un oxyde inorganique et ladite seconde couche ayant une couche de protection électrique qui comprend un matériau conducteur ;
c) la stratification desdites première et seconde couches ensemble pour former une feuille-fenêtre ; et
d) le scellage de ladite feuille-fenêtre sur ledit corps en travers de ladite ouverture, de façon à intégrer ladite feuille-fenêtre dans ledit corps en tant que fenêtre de celui-ci, moyennant quoi ladite fenêtre est utilisable pour visualiser des articles à l'intérieur dudit emballage, par exemple des marchandises ou un marquage.
